# EUROPEAN PATENT SPECIFICATION

(11) **EP 2 887 784 B1**
(45) Date of publication and mention of the grant of the patent: **10.04.2019**
(21) Application number: 13839889.6
(22) Date of filing: 29.08.2013
(51) Int. Cl.: H01L 23/40

(54) **RADIATOR FIXING DEVICE**
HEIZUNGSBEFESTIGUNGSVORRICHTUNG
DISPOSITIF DE FIXATION D'ÉLÉMENT RAYONNANT

(30) Priority: 20.09.2012 CN 201220481116 U
(43) Date of publication of application: 24.06.2015
(73) Proprietor: ZTE Corporation, Shenzhen, Guangdong 518057 (CN)
(72) Inventor: ZHANG, Weifeng, Shenzhen Guangdong 518057 (CN)
(74) Representative: Schröer, Gernot H.
(86) International application number: PCT/CN2013/082543
(87) International publication number: WO 2014/044114

(56) References cited:
- CN-A- 101 336 062
- CN-A- 101 616 563
- CN-U- 202 841 813
- CN-Y- 2 416 612
- CN-Y- 200 966 203
- JP-A- 2000 236 185
- US-A1- 2005 141 201
- US-A1- 2006 032 619
- US-B1- 7 796 390

## Description

### Technical Field

The present invention relates to a fixing device applied to an electronic device, and more particularly, to a fixing device for a radiator of an integrated circuit chip.

### Background of the Invention

Since the running speed of IC (Integrated Circuit) chips is faster and faster, more heat is generated, therefore some of the IC chips are equipped with IC radiators to assist dissipating heat to make the IC chips maintain a more secure operating temperature.

Typically, an IC chip is soldered on a printed circuit board, and an IC radiator is bonded to the surface of the IC chip, to dissipate the heat of the IC chip to the IC radiator by conduction. Currently, typical methods for fixing the existing IC radiators are structure member fixing, heat-conducting glue adhesion, etc., wherein the structure member fixing is typically providing a hole on a printed circuit board to connect the IC radiator with the printed circuit board via the structure member such as a bolt or the like.

In the process of implementing the technical scheme of the present invention, the inventors have found that since in the relevant structure member fixing method, a hole is opened on the printed circuit board, the fixing structure occupies a relatively large area on the printed circuit board, reducing the available area for wiring on internal and external layers of the printed circuit board, and increasing the difficulty of layout design of the printed circuit board, especially the multi-layer printed circuit board. While the heat-conducting glue adhesion method has the risk of glue aging and falling-off, reducing the radiating performance and operation reliability.

Relevant background art is described in US 2005/141201 A1 (CHEN CHUN-CHI [TW] ET AL) 30 June 2005 (2005-06-30), or US 7 796 390 B1 (CAO LEI [CN] ET AL) 14 September 2010 (2010-09-14).

### Summary of the Invention

To solve the technical problem, the present invention is to provide a radiator fixing device to effectively reduce the area occupied by the radiator fixing structure on a printed circuit board.

To solve the abovementioned technical problem, the present invention provides a radiator fixing device, comprising a hook member at a radiator end and a snap member at a printed circuit board end, and the snap member is fixed on the printed circuit board with a surface-mounting technology, and the hook member is sleeved with an elastic member, and is snap-connected with the snap member by passing through a mounting hole provided on the radiator, to fix the radiator on the printed circuit board.

Preferably, the hook member comprises a column body, a column cap and a hook, wherein the column cap is provided at one end of the column body, the hook is provided at the other end of the column body, and the hook is vertical to the column body to form a L-shaped hook.

Preferably, the snap member is a rectangular frame with one open end, and the open end is provided with a snap to form a C-shaped snap; the hook member is sleeve-connected with an elastic member, then passes through the mounting hole on the radiator and compresses the elastic member, the hook of the hook member is rotated after reaching into the open end of the snap member to make the C-shaped snap hook up the L-shaped hook.

Preferably, the hook member comprises a column body, a column cap and a tenon, the column cap is provided at one end of the column body, the tenon is provided at the other end of the column body, and the tenon is vertical to the column body to form a L-shaped tenon.

Preferably, the snap member has a sleeve structure, an arc-shaped slide is provided on a sidewall of the sleeve, and an end of the slide is provided with a slot; the hook member is sleeve-connected with the elastic member, then passes through the mounting hole on the radiator and compresses the elastic member, and the tenon of the hook member enters into the slot along the slide to make the slot hook up the L-shaped tenon.

On the basis of the abovementioned technical scheme, the radiator is a radiator of an integrated circuit chip, and the integrated circuit chip is soldered on the printed circuit board, and a radiating surface of the radiator of the integrated circuit chip is bonded to a surface of the integrated circuit chip.

Preferably, there are two or more snap members, which are provided at the periphery of the integrated circuit chip.

Preferably, the snap member is soldered on the printed circuit board.

Preferably, the hook member and the snap member are metal or non-metal, and are made with a casting or machining technology.

Preferably, the elastic member is a spring or a metallic clip.

The embodiment of the present invention provides a radiator fixing device, to avoid opening a hole on a printed circuit board, effectively reduce the area occupied by a fixing structure on the printed circuit board, increase the available area for wiring on the printed circuit board, and reduce the difficulty of layout design of the printed circuit board, and it has a simple structure and is easy to install, and the connection is reliable. Furthermore, for a multilayer printed circuit board structure, since the snap member according to the embodiment of the present invention is only provided on the surface of the first layer of the printed circuit board, the available area for wiring on the printed circuit board is increased to a greater extent.

### Brief Description of the Drawings

Fig. 1 is a block diagram of a first embodiment of the radiator fixing structure in accordance with the present invention;
FIG. 2a and
FIG. 2b are block diagrams of the first hook member in accordance with an embodiment of the present invention;
FIG. 3 is a block diagram of the first snap member in accordance with an embodiment of the present invention;
FIG. 4 is a block diagram of the first hook member connecting with the first snap member in accordance with an embodiment of the present invention;
FIG. 5 is a block diagram of a second embodiment of the radiator fixing device in accordance with the present invention;
FIG. 6 is a block diagram of the second hook member in accordance with an embodiment of the present invention;
FIG. 7 is a block diagram of the second snap member in accordance with an embodiment of the present invention.

### Preferred Embodiments of the Invention

Hereinafter in conjunction with the accompanying drawings, the technical scheme of the present invention will be described in further detail.

The radiator fixing device according to the embodiment of the present invention comprises a snap member at the radiator end and a hook member at the printed circuit board end, the snap member is fixed on the printed circuit board with a surface mounting technology and is provided at the periphery of the IC chip, the radiator is provided with a mounting hole, and the hook member which is sleeved with an elastic member passes through the mounting hole and snap-connected with the snap member to fix the radiator on the printed circuit board. In practical applications, a radiator can be fixed with two or more radiator fixing devices according to the embodiment of the present invention. With the radiator fixing device according to the embodiment of the present invention, opening a hole on the printed circuit board is avoided, it effectively reduces the area occupied by the fixing structure on the printed circuit board, increases the available area for wiring on the printed circuit board, and reduces the difficulty of layout design of the printed circuit board, and it has a simple structure and is easy to install, and the connection is reliable. Furthermore, for a multilayer printed circuit board structure, because the snap member according to the embodiment of the present invention is only provided on the surface of the first layer of the printed circuit board, it increases the available area for wiring on the printed circuit board to a greater extent.

The radiator fixing device according to the embodiment of the present invention may be implemented in at least two structures, the L-shaped hook and the pressing hook.

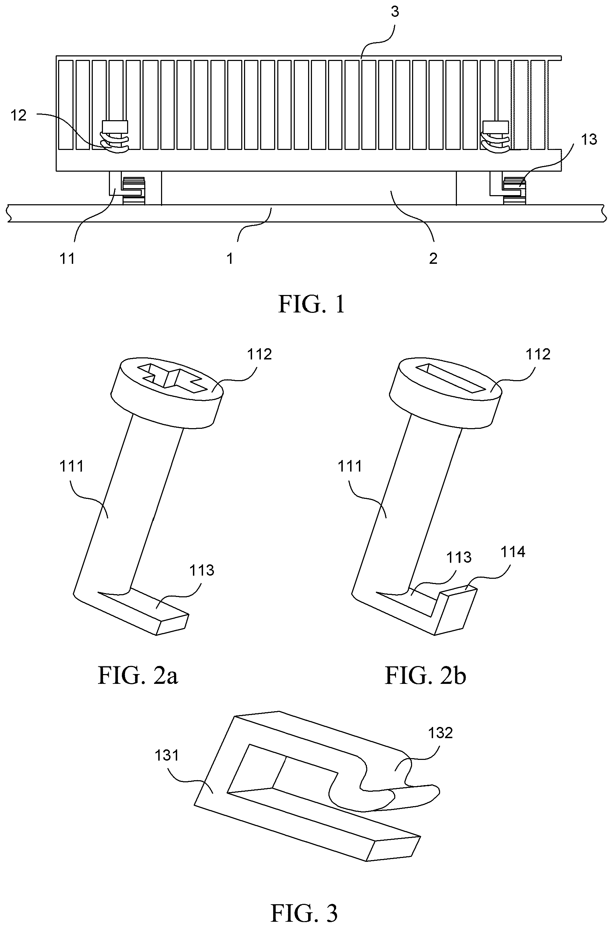

FIG. 1 is a block diagram of a first embodiment of the radiator fixing device in accordance with an embodiment of the present invention. As shown in FIG. 1, the radiator fixing device according to the present embodiment is in a way of the L-shaped hook, comprising a first hook member 11, a first elastic member 12 and a first snap member 13, the first hook member 11 which is sleeved with the first elastic member 12 is snap-connected with the first snap member 13 to fix the radiator 3 which is bonded to the surface of the IC chip 2 on the printed circuit board 1. Specifically, the IC chip 2 is soldered on the printed circuit board, and the first snap member 13 is provided at the periphery of the IC chip 2 (e.g., both ends or four corners), and is fixed on the printed circuit board 1 with the surface-mounting technology, the radiator 3 is provided with a mounting hole, the radiating surface of the radiator 3 is bonded to the surface of the IC chip 2, the first hook member 11 which is sleeved with the first elastic member 12 passes through the mounting hole and is snap-connected with the first snap member 13, to realize the fixed connection between the radiator 3 and the printed circuit board 1.

FIG. 2a and FIG. 2b are block diagrams of the first hook member in accordance with an embodiment of the present invention. As shown in FIG. 2a, the first hook member 11 according to the embodiment of the present invention comprises a column body 111, a column cap 112 and a hook 113, the column cap 112 is provided at one end of the column body 111, and the hook 113 is provided at the other end of the column body 111, the hook 113 is vertical to the column body 111 to form a L-shaped hook. In practical applications, the first hook member according to the embodiment of the present invention can be expanded or deformed into a variety of structure forms, for example, on the basis of the L-shaped hook, an end of the hook may be provided with a projection114 to enhance the hooking reliability, as shown in FIG. 2b. The surface of the column cap 112 can be provided with a straight-line, cross or other shaped recess, to facilitate using tools to unlock the first hook member when removing the radiator.

FIG. 3 is a block diagram of the first snap member in accordance with the embodiment of the present invention. As shown in FIG. 3, the first snap member in accordance with the embodiment of the present invention is a rectangular frame 131 with one open end, and the open end is provided with a snap 132 to form a C-shaped snap. In practical applications, the snap member can be soldered on the printed circuit board, the elastic member can be a spring or metallic clip, and the first hook member and the first snap member can be made of metallic or non-metallic wires, rods, plates with the casting or machining technology.

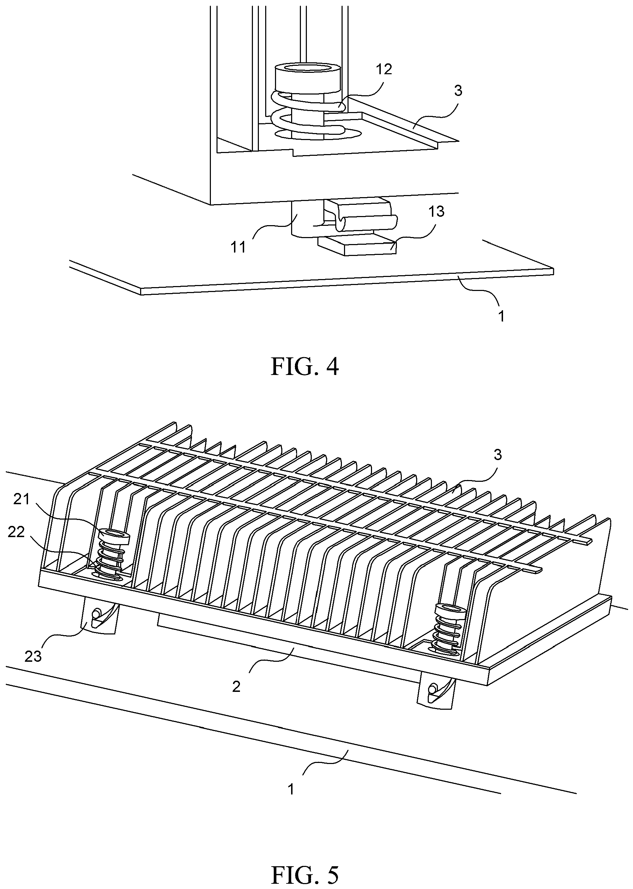

FIG. 4 is a block diagram of the first hook member connecting with the first snap member in accordance with the embodiment of the present invention. As shown in FIG. 4, the first snap member 13 is soldered on the printed circuit board 1, and the radiator 3 is provided with a mounting hole, and the hook member 11 is sleeve-connected with the first sleeve 12, then passes through the mounting hole on the radiator 3 and compresses the first elastic member 12 such as an elastic spring or clip, until the L-shaped hook of the first hook 11 reaches into the open end of the first snap member 13, and the first hook member 11 is rotated toward the inside direction of the C-shaped snap until the C-shaped snap hooks up the L-shape hook. By providing the first elastic member 12 on the structure according to the embodiment of the present invention, the first elastic member 12 provides an upward push to the first hook member 11, making the L-shaped hook firmly hook up the C-shaped snap. Thus, the radiator 3 is fixed on the printed circuit board 1 with two or more the first hook members and the first snap members in accordance with the embodiment of the present invention, and the radiating surface of the radiator is bonded to the surface of the IC chip.

The radiator fixing device according to the present embodiment fixes the radiator on the printed circuit board through the L-shaped hook and the C-shaped snap, to avoid opening a hole on the printed circuit board, effectively reduce the available area occupied by the fixing structure on the printed circuit board, and it has a simple structure and is easy to install, and the connection is reliable.

FIG. 5 is a block diagram of a second embodiment of the radiator fixing device in accordance with an embodiment of the present invention. As shown in FIG. 5, the radiator fixing device according to the present embodiment is in a way of a pressing hook, comprising a second hook member 21, a second elastic member 22 and a second snap member 23, the second hook member 22 which is sleeved with the second elastic member 21 is snap-connected with the second snap member 23, to fix the radiator 3 which is bonded to the surface of the IC chip 2 on the printed circuit board 1. Specifically, the IC chip 2 is soldered on the printed circuit board 1, the second snap member 23 is provided at the periphery of the IC chip 2 (e.g., both ends or four corners) and is fixed on the printed circuit board 1 with the surface-mounting technology, and the radiator 3 is provided with a mounting hole, the radiating surface of the radiator 3 is bonded to the surface of the IC chip 2, and the second hook member 21 which is sleeved with the second elastic member 22 passes through the mounting hole and is snap-connected with the second snap member 23, to achieve the fixed connection between the radiator 3 and the printed circuit board 1.

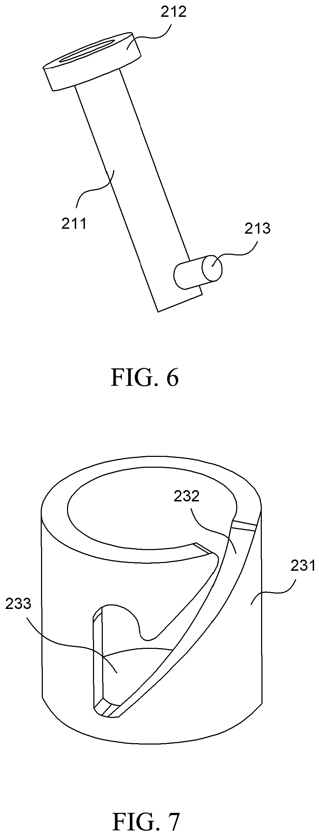

FIG. 6 is a block diagram of the second hook member in accordance with the embodiment of the present invention. As shown in FIG. 6, the second hook member 21 according to the embodiment of the present invention comprises a column body 211, a column cap 212 and a tenon 213, the column cap 212 is provided at one end of the column body 211, the tenon 213 is provided at the other end of the column body 211, and the tenon 213 is vertical to the column body 211 to form a L-shaped tenon. The surface of can the column cap 212 can be provided with a straight-line, cross or other shaped recess, to facilitate using tools to unlock the second hook member when removing the radiator.

FIG. 7 is a block diagram of the second snap member in accordance with the embodiment of the present invention. As shown in FIG. 7, the second snap member according to the embodiment of the present invention has a sleeve structure, and the sidewall 231 of the sleeve is provided with arc-shaped slide 232, the end of the slide 232 is provided with slot 233. There may be one, or two, or more tenons 213 of the second hook member 21 according to the embodiment of the present invention, thereby increasing the connection reliability. When there are two or more tenons, the sidewall of the sleeve of the second snap member is provided with the appropriate number of arc-shaped slides and slots. In practical applications, the snap member can be soldered on the printed circuit board, the elastic member can be a spring or metallic clip, the second snap member and the second hook member can be made of metallic or non-metallic wires, rods, plates or other materials with the casting or machining technology.

As shown in FIG. 5, the way of fixing according to the present embodiment is that: the second snap member 23 is soldered on the printed circuit board 1, and the radiator 3 is provided with a mounting hole, the second hook member 21 is sleeve-connected with the second elastic member 22, passes through the mounting hole on the radiator 3 and compresses the second elastic member 22 such as a spring or clip to make the tenon of the second hook member 21 enter into the slot along the slide of the second snap member until the slot hooks up the tenon. By providing the second elastic member 22 in the structure according to the embodiment of the present invention, the second elastic member 22 provides an upward push to the second hook member 21, making the tenon securely hook in the slot. Thus, the radiator 3 is fixed on the printed circuit board 1 by two or more the second hook members and the second snap members according to the embodiment of the present invention, and the radiating surface of the radiator is bonded to the surface of the IC chip.
The radiator fixing device according to the present embodiment fixes the radiator on the printed circuit board via the tenon and the slot, to avoid opening a hole on the printed circuit board and effectively reduce the area occupied by the fixing structure on the printed circuit board, and it has a simple structure and is easy to install, and the connection is reliable.

The above description is only preferred embodiments of the present invention but not intended to limit the present invention, and for a person skilled in the art, the present invention may have various modifications and changes. Any modifications, equivalent replacements or improvements made within the spirit and principles of the present invention should be included within the protection scope of the present invention.

### Industrial Applicability

The embodiment of the present invention provides a radiator fixing device, to avoid opening a hole on a printed circuit board, effectively reduce the area occupied by a fixing structure on the printed circuit board, increase the available area for wiring on the printed circuit board and reduce the difficulty of layout design of the printed circuit board, and it has a simple structure and is easy to install, and the connection is reliable. Furthermore, for a multilayer printed circuit board structure, since the snap member according to the embodiment of the present invention is only provided on the surface of the first layer of the printed circuit board, the available area for wiring on the printed circuit board is increased to a greater extent.

## Claims

1. A radiator fixing device, comprising a hook member at a radiator end and a snap member at a printed circuit board end, wherein the snap member is fixed on the printed circuit board with a surface-mounting technology, and the hook member is sleeved with an elastic member, passes through a mounting hole provided on the radiator and is snap-connected with the snap member to fix the radiator on the printed circuit board.

2. The radiator fixing device of claim 1, wherein, the hook member comprises a column body, a column cap and a hook, the column cap is provided at one end of the column body, the hook is provided at another end of the column body, and the hook is vertical to the column body to form a L-shaped hook.

3. The radiator fixing device of claim 2, wherein, the snap member is a rectangular frame with one open end, and the open end is provided with a snap to form a C-shaped snap; the hook member is sleeve-connected with an elastic member, then passes through the mounting hole on the radiator and compresses the elastic member, the hook of the hook member is rotated after reaching into the open end of the snap member to make the C-shaped snap hook up the L-shaped hook.

4. The radiator fixing device of claim 1, wherein, the hook member comprises a column body, a column cap and a tenon, the column cap is provided at one end of the column body, the tenon is provided at another end of the column body, and the tenon is vertical to the column body to form a L-shaped tenon.

5. The radiator fixing device of claim 4, wherein, the snap member has a sleeve structure, an arc-shaped slide is provided on a sidewall of the sleeve, and an end of the slide is provided with a slot; the hook member is sleeve-connected with the elastic member, then passes through the mounting hole on the radiator and compresses the elastic member, and the tenon of hook member enters into the slot along the slide to make the slot hook up the L-shaped tenon.

6. The radiator fixing device of any one of claims 1 to 5, wherein, the radiator is a radiator of an integrated circuit chip, and the integrated circuit chip is soldered on the printed circuit board, and a radiating surface of the radiator of the integrated circuit chip is bonded to a surface of the integrated circuit chip.

7. The radiator fixing device of claim 6, wherein, there are two or more snap members, which are provided at the periphery of the integrated circuit chip.

8. The radiator fixing device of any one of claims 1 to 5, wherein, the snap member is soldered on the printed circuit board.

9. The radiator fixing device of any one of claims 1 to 5, wherein, the hook member and the snap member are metal or non-metal and are made with a casting or machining technology.

10. The radiator fixing device of any one of claims 1 to 5, wherein, the elastic member is a spring or metallic clip.

## Patentansprüche

1. Kühlerbefestigungsvorrichtung, umfassend ein Hakenelement an einem Kühlerende und ein Schnappelement an einem Ende einer gedruckten Leiterplatte, wobei das Schnappelement auf der gedruckten Leiterplatte mit einer Oberflächenmontage-Technologie befestigt ist und das Hakenelement mit einem elastischen Element umhüllt ist, durch ein Montageloch verläuft, das auf der Heizung bereitgestellt ist, und mit dem Schnappelement rastend verbunden ist, um den Kühler auf der gedruckten Leiterplatte zu befestigen.

2. Kühlerbefestigungsvorrichtung nach Anspruch 1, wobei das Hakenelement einen Säulenkörper, eine Säulenkappe und einen Haken umfasst, die Säulenkappe an einem Ende des Säulenkörpers bereitgestellt ist, der Haken an einem anderen Ende des Säulenkörpers bereitgestellt ist und der Haken vertikal zu dem Säulenkörper verläuft, um einen L-förmigen Haken zu bilden.

3. Kühlerbefestigungsvorrichtung nach Anspruch 2, wobei das Schnappelement ein rechteckiger Rahmen mit einem offenen Ende ist und das offene Ende mit einem Schnappschloss bereitgestellt ist, um einen C-förmigen Schnappverschluss zu bilden; das Hakenelement über eine Hülse mit einem elastischen Element verbunden ist, dann durch das Montageloch auf der Heizung verläuft und das elastische Element zusammendrückt, der Haken der Hakenelements gedreht wird, nachdem er das offene Ende des Schnappelements erreicht hat, damit der C-förmige Schnapphaken in den L-förmigen Haken einhakt.

4. Kühlerbefestigungsvorrichtung nach Anspruch 1, wobei das Hakenelement einen Säulenkörper, eine Säulenkappe und einen Zapfen umfasst, die Säulenkappe an einem Ende des Säulenkörpers bereitgestellt ist, der Zapfen an einem anderen Ende des Säulenkörpers bereitgestellt ist und der Zapfen vertikal zu dem Säulenkörper verläuft, um einen L-förmigen Zapfen zu bilden.

5. Kühlerbefestigungsvorrichtung nach Anspruch 4, wobei das Schnappelement eine Hülsenstruktur aufweist, eine bogenförmige Gleitfläche auf einer Seitenwand der Hülse bereitgestellt ist und ein Ende der Gleitfläche mit einem Schlitz bereitgestellt ist; das Hakenelement über eine Hülse mit dem elastischen Element verbunden ist, dann durch das Montageloch auf der Heizung verläuft und das elastische Element zusammendrückt, und der Zapfen des Hakenelements entlang der Gleitfläche in den Schlitz gelangt, damit der Schlitz in den L-förmigen Zapfen einhaken kann.

6. Kühlerbefestigungsvorrichtung nach einem der Ansprüche 1 bis 5, wobei der Kühler ein Kühler eines integrierten Schaltungschips ist und der integrierte Schaltungschip auf der gedruckten Leiterplatte verlötet ist, und eine Abstrahlfläche des Kühlers des integrierten Schaltungschips mit einer Oberfläche des integrierten Schaltungschips verbunden ist.

7. Kühlerbefestigungsvorrichtung nach Anspruch 6, wobei zwei oder mehrere Schnappelemente vorhanden sind, die am Umfang des integrierten Schaltungschips bereitgestellt sind.

8. Kühlerbefestigungsvorrichtung nach einem der Ansprüche 1 bis 5, wobei das Schnappelement auf der gedruckten Leiterplatte verlötet ist.

9. Kühlerbefestigungsvorrichtung nach einem der Ansprüche 1 bis 5, wobei das Hakenelement und das Schnappelement Metall oder Nichtmetall sind und mit einer Gießtechnologie oder Bearbeitungstechnik hergestellt sind.

10. Kühlerbefestigungsvorrichtung nach einem der Ansprüche 1 bis 5, wobei das elastische Element eine Feder oder ein Metallclip ist.

## Revendications

1. Dispositif de fixation d'élément rayonnant, comprenant un élément crochet à une extrémité d'élément rayonnant et un élément d'attache à une extrémité de carte de circuits imprimés, l'élément d'attache étant fixé sur la carte de circuits imprimés avec une technologie de montage en surface, et l'élément crochet étant entouré d'un élément élastique, passant à travers un trou de montage prévu sur l'élément rayonnant et étant relié par emboîtage élastique à l'élément d'attache pour fixer l'élément rayonnant sur la carte de circuits imprimés.

2. Dispositif de fixation d'élément rayonnant selon la revendication 1, dans lequel l'élément crochet comprend un corps de colonne, un capuchon de colonne et un crochet, le capuchon de colonne est prévu à une extrémité du corps de colonne, le crochet est prévu à une autre extrémité du corps de colonne, et le crochet est perpendiculaire au corps de colonne pour former un crochet en forme de L.

3. Dispositif de fixation d'élément rayonnant selon la revendication 2, dans lequel l'élément d'attache est un cadre rectangulaire avec une extrémité ouverte, et l'extrémité ouverte comporte une attache pour former une attache en forme de C; l'élément crochet est relié, par emmanchement, à un élément élastique, puis passe à travers le trou de montage sur l'élément rayonnant et comprime l'élément élastique, le crochet de l'élément crochet est tourné après avoir atteint l'extrémité ouverte de l'élément d'attache pour amener l'attache en forme de C à s'accrocher au crochet en forme de L.

4. Dispositif de fixation d'élément rayonnant selon la revendication 1, dans lequel l'élément crochet comprend un corps de colonne, un capuchon de colonne et un tenon, le capuchon de colonne est prévu à une extrémité du corps de colonne, le tenon est prévu à une autre extrémité du corps de colonne, et le tenon est perpendiculaire au corps de colonne pour former un tenon en forme de L.

5. Dispositif de fixation d'élément rayonnant selon la revendication 4, dans lequel l'élément d'attache a une structure de manchon, une glissière en forme d'arc est prévue sur une paroi latérale du manchon, et une extrémité de la glissière comporte une fente; l'élément crochet est relié par emmanchement à l'élément élastique, puis passe à travers le trou de montage sur l'élément rayonnant et comprime l'élément élastique, et le tenon de l'élément crochet entre dans la fente le long de la glissière pour amener la fente à s'accrocher au tenon en forme de L.

6. Dispositif de fixation d'élément rayonnant selon l'une quelconque des revendications 1 à 5, dans lequel l'élément rayonnant est un élément rayonnant d'une puce à circuit intégré, et la puce à circuit intégré est soudée sur la carte de circuits imprimés, et une surface rayonnante de l'élément rayonnant de la puce à circuit intégré est collée à une surface de la puce à circuit intégré.

7. Dispositif de fixation d'élément rayonnant selon la revendication 6, dans lequel il y a au moins deux éléments d'attache, qui sont prévus à la périphérie de la puce à circuit intégré.

8. Dispositif de fixation d'élément rayonnant selon l'une quelconque des revendications 1 à 5, dans lequel l'élément d'attache est soudée sur la carte de circuits imprimés.

9. Dispositif de fixation d'élément rayonnant selon l'une quelconque des revendications 1 à 5, dans lequel l'élément crochet et l'élément d'attache sont métalliques ou non-métalliques et sont réalisés avec une technologie de moulage ou d'usinage.

10. Dispositif de fixation d'élément rayonnant selon l'une quelconque des revendications 1 à 5, dans lequel l'élément élastique est un ressort ou une agrafe métallique.
